# EUROPEAN PATENT APPLICATION

(11) **EP 4 474 847 A1**
(43) Date of publication of application: **11.12.2024**
(21) Application number: 23178321.8
(22) Date of filing: 09.06.2023
(51) Int. Cl.: G01R 33/565, G01R 33/56, G01R 33/561, G01R 33/48

(54) **MAGNETIC RESONANCE IMAGE DENOISING**

(71) Applicant: Koninklijke Philips N.V., 5656 AG Eindhoven (NL)
(72) Inventor: EGGERS, Holger, Eindhoven (NL)
(74) Representative: Philips Intellectual Property & Standards

(57) **Abstract**

Disclosed herein is a method for magnetic resonance image reconstruction. The method comprises:
receiving subsampled k-space data that have been acquired for imaging a subject;
reconstructing from the subsampled k-space data at least one aliased image using a first magnetic resonance image reconstruction method; denoising the at least one aliased image; deriving from the at least one denoised aliased image k-space data, referred to as denoised k-space data, using a Fourier transformation; reconstructing from the denoised k-space data a magnetic resonance image of the subject using a second magnetic resonance image reconstruction method, the second magnetic resonance image reconstruction method comprising the first magnetic resonance image reconstruction method and additional processing operations.

## Description

### FIELD OF THE INVENTION

The invention relates to magnetic resonance imaging, in particular to denoising of magnetic resonance (MR) images.

### BACKGROUND OF THE INVENTION

The conventional magnetic resonance image reconstruction process is a pipeline of processing steps including, for example, a Fourier transformation step, a noise decorrelation step, a filtering step, an image interpolation step, etc. The resulting reconstructed images may exhibit a spatially varying noise level, which may depend on the sensitivity of the receive coil elements and on the sampling pattern of the acquisition. They also feature local and global noise correlation, especially if the acquisition is accelerated by subsampling. Both phenomena complicate the denoising, since they either are accurately modeled in the training, in which case the denoising gets tailored to a particular acquisition and loses wider applicability, or they are broadly covered in the training, in which case the denoising suffers from suboptimal performance due to excessive generalization.

### SUMMARY OF THE INVENTION

The invention provides for a medical system, a computer program and a method in the independent claims. Embodiments are given in the dependent claims.

Embodiments may perform a denoising trained to remove white noise on aliased images, each of which is straightforwardly reconstructed with a Fourier transform from subsampled k-space data acquired with a single receive coil element. Since the noise level in these aliased images is uniform and the noise is uncorrelated, the loss of wider applicability or optimal performance, as experienced with a dedicated or general denoising applied to conventionally reconstructed images, respectively, may be avoided.

In one aspect the invention provides for a medical system for magnetic resonance image reconstruction. The medical system comprises: a memory storing machine executable instructions; and a computational system, wherein execution of the machine executable instructions causes the computational system to: receive subsampled k-space data that have been acquired for imaging a subject; reconstruct from the subsampled k-space data at least one aliased image using a first magnetic resonance image reconstruction method; denoise the at least one aliased image; derive from the at least one denoised aliased image k-space data, referred to as denoised k-space data, using a Fourier transformation; reconstruct from the denoised k-space data a magnetic resonance image of the subject using a second magnetic resonance image reconstruction method, the second magnetic resonance image reconstruction method comprising the first magnetic resonance image reconstruction method and additional processing operations. The terms "processing step" and "processing operation" are used herein interchangeably.

The present subject matter may provide a magnetic resonance image of a volume of the subject. The volume may, for example, be a shoulder, a heart, a brain or any other part of the subject that can be imaged by a magnetic resonance imaging system. In one example, the magnetic resonance imaging system may be remote from the medical system. This may enable a flexible implementation of the present subject matter. For example, the medical system may be configured to perform the present method using k-space data acquired by multiple remote magnetic resonance imaging systems (e.g., in a hospital). Alternatively, the medical system may comprise the magnetic resonance imaging system. This may enable local processing of acquired k-space data, e.g., during scanning of the subject.

The magnetic resonance image of the volume may be obtained by applying a specific acquisition technique and an image reconstruction scheme. The acquisition technique may be performed in accordance with a spatial resolution. The spatial resolution may be defined by a field of view (FOV) and a matrix size. The matrix size may be the number of frequency encoding steps and the number of phase encoding steps. The field of view may define the size of the area that said matrix covers. The acquisition technique may, thus, define the size of k-space, the initial number of samples in the k-space and a sampling pattern of the samples in the k-space.

The acquisition technique may use a pulse sequence to fill samples in the k-space. The k-space may be filled partially by acquiring fewer samples than the initial number of samples. In this case, the acquired k-space data may be referred to as undersampled k-space data or subsampled k-space data. This may save scan time while maintaining the spatial resolution. The k-space subsampling may be performed in any encoding direction such as the partition encoding direction. In one example, the k-space subsampling may be performed in the phase encoding direction by reducing the number of k-space lines. However, the missing information of the non-collected k-space samples may lead to image aliasing due to a reduction of the desired field of view. Indeed, if the Nyquist criterion is not met, the field of view becomes smaller than the volume and an aliased image results. For example, if the volume is larger in the phase direction than the reduced field of view, foldover artifacts may appear.

In one example, the received subsampled k-space data may be k-space data which is acquired from one or more slices of the volume. The subsampled k-space data may represent a number S of slices, where S is higher than or equal to one. The received subsampled k-space data may be acquired by one or more receive coils of the magnetic resonance imaging system. The received subsampled k-space data may be acquired by a number R of receive coils, where R is higher than or equal to one. Thus, the structure of the received subsampled k-space data may be provided depending on the acquisition technique and the number of receive coils. The receive coils may also be referred to as receive coil elements, receiver coils, or radiofrequency receive coils. Indeed, radiofrequency radiation may be transmitted into the subject where it excites the tissue magnetization. Radiofrequency signals are then emitted from the tissue. The radiofrequency receive coils may be used to receive a superposition of these radiofrequency signals.

The image reconstruction scheme may process the k-space data to yield reconstructed magnetic resonance images. In particular, the present image reconstruction scheme may provide a magnetic resonance image of the volume with an optimal reduction of noise. For that, the reconstruction scheme is defined by two magnetic resonance image reconstruction methods herein referred to as the first magnetic resonance image reconstruction method and the second magnetic resonance image reconstruction method, respectively. The second magnetic resonance image reconstruction method may, for example, be a conventional magnetic resonance image process comprising the full pipeline to reconstruct the magnetic resonance image. The second magnetic resonance image reconstruction method may comprise the first magnetic resonance image reconstruction method and additional processing steps. Each additional processing step of the additional processing steps may process k-space data and/or image space data that results from a reconstruction of the k-space data.

The first magnetic resonance image reconstruction method may, for example, comprise a minimum number of steps of the pipeline that enable to obtain a magnetic resonance image. The first magnetic resonance image reconstruction method may, for example, be derived from the second magnetic resonance image reconstruction method. The first magnetic resonance image reconstruction method may be the second magnetic resonance image reconstruction method excluding at least part of the additional processing steps. Thus, the spatial distribution and/or spatial correlation of the noise in an image produced by the first magnetic resonance image reconstruction method is different from (e.g., more uniform than) the noise distribution in an image reconstructed using the second magnetic resonance image reconstruction method only.

The first magnetic resonance image reconstruction method may be used to reconstruct from the received subsampled k-space data at least one aliased image. For example, a number N of aliased images may be reconstructed from the received subsampled k-space, where N is an integer higher than or equal to one (N>=1).

For example, the subsampled k-space data may comprise subsets of k-space data. Each subset of k-space data of the subsets of k-space data may be received by a specific receive coil of multiple receive coils and/or represent one or more specific slices of the volume. Each subset of k-space data of the subsets of k-space data may have the same field of view. In addition, each subset of k-space data of the subsets of k-space data may have the same sampling pattern. This may enable a uniform subsampling. The uniform subsampling may lead to pronounced aliasing, since only a few shifted replicas of the original image superimpose. The uniform subsampling may thus be easier to handle for typical denoising methods than a nonuniform subsampling. In this example, the first magnetic resonance image reconstruction method may be used to reconstruct from the received subsampled k-space data multiple aliased images, wherein each aliased image is obtained from a respective subset of the k-space data. The second magnetic resonance image reconstruction method may, for example, be configured to perform a parallel imaging (PI) reconstruction technique.

Alternatively, the subsampled k-space data may be received by one receive coil and represent one slice (S=1, R=1). In this case, the first magnetic resonance image reconstruction method may be used to reconstruct from the received subsampled k-space data one aliased image (N=1), or the first magnetic resonance image reconstruction method may be executed multiple times on the received subsampled k-space to reconstruct multiple aliased images (N>1). The multiple images may be combined (e.g., averaged) to obtain one image.

The N aliased images may be denoised in order to obtain N denoised images, respectively. The denoising may, for example, be performed by inputting the N aliased images to a noise filtering module. In response to receiving the N aliased images as input, the noise filtering module may output the N denoised images. The noise filtering module may denoise the N aliased images sequentially or in parallel. The noise filtering module may be a software module. The noise filtering module may, for example, be configured to remove an additive noise from the input magnetic resonance image. For example, the additive noise may be white noise. The denoising may, thus, remove white noise from the N aliased images.

A Fourier transformation may be applied to the N denoised aliased images in order to derive k-space data, herein referred to as denoised k-space data. The Fourier transformation may be a 2-dimensional discrete Fourier transformation. The sampling pattern of the denoised k-space data may be the same as the sampling pattern of the received subsampled k-space data. The magnetic resonance image of the volume may be reconstructed from the denoised k-space data using the second image reconstruction method.

The present subject matter may have the following advantages. The aliased images may be straightforwardly reconstructed from subsampled k-space data with a Fourier transform. Since the noise level in these aliased images may be uniform and uncorrelated, the loss of wider applicability or optimal performance of the denoising method may be avoided. In addition, different types of denoising methods may be used. These may include denoising methods which do not have the ability to generalize from the types of images they were trained on to other type of images.

In one example, the subsampled k-space data may comprise multiple subsets of k-space data. The subsampling may be performed in the phase encoding direction by reducing the number of k-space lines. The subsets of k-space data are subsampled in the same way. That is, each subset of the subsets of k-space data may cover the same area, have the same number of samples following the same sampling pattern. Such a uniform subsampling may lead to pronounced aliasing since only a few shifted replicas of the original image superimpose. This may be much easier to handle for typical denoising methods than a nonuniform subsampling, which may lead to more noise-like aliasing. This example may be applied to both standard Sensitivity Encoding (SENSE) and to the individual blades in Periodically Rotated Overlapping Parallel Lines with Enhanced Reconstruction (PROPELLER) imaging.

As k-space data goes through the reconstruction pipeline, both the signal and the noise are subjected to the same processing steps and finally both signal and noise are mapped to each individual pixel in the image. However, some or all of the additional processing steps may induce a spatially correlated and/or spatially variant noise that is mapped to the magnetic resonance image. Accordingly, the present subject matter may provide the first magnetic resonance image reconstruction method.

According to one example, the first magnetic resonance image reconstruction method is a Fourier transformation operation. That is, the first magnetic resonance image reconstruction is the second magnetic resonance image reconstruction excluding all additional processing steps. Excluding all the additional processing steps may avoid introducing spatial correlation or spatial variation of the noise intentionally or unintentionally. This example may further have the advantage of speeding up the present method while still improving the denoising of magnetic resonance images. The present method may be sped up because the aliased images may straightforwardly be reconstructed with a Fourier transform.

According to one example, a subset of the additional processing steps may be selected so that the first magnetic resonance image reconstruction method comprises a Fourier transformation step and the selected subset of processing steps. The selected subset of processing steps may be referred to as maintained steps. The remaining processing steps which are not selected may be referred to as excluded steps. The excluded steps may be processing steps which are non-uniformly applied to the subsampled k-space data and/or to the respective image data. The excluded steps may be processing steps which induce spatial correlation and/or spatial variation of the noise. Indeed, the algorithm(s) used in the excluded steps may be very complex and nonlinear, rendering the effect on the noise distribution complicated or even unpredictable. For example, any algorithm that processes one pixel in dependence of other pixels (e.g., neighboring pixels) may induce spatially correlated noise or spatially varying noise. In contrast to the previous example, the first magnetic resonance image reconstruction method is not limited to the Fourier transformation as it only excludes the steps that induce spatially correlated and/or spatially variant noise. The selection of the maintained steps may, for example, comprise receiving an input from a user, wherein the input indicates the processing steps to be excluded, and performing the selection according to the input. Alternatively, the selection of the maintained steps may be automatically performed, e.g., using predefined rules.

Excluding a specific part of the additional processing steps may improve both the denoising of magnetic resonance images and the produced aliased images for the following reasons. The maintained processing steps may enable improved aliased images compared to applying the Fourier transformation only. The improved aliased images may enable an improved denoising.

According to one example, the subsampled k-space data are acquired using multiple receive coils of the magnetic resonance imaging system. The subsampled k-space data may comprise a subset of k-space data per receive coil, e.g., each subset may be received by a respective receive coil. In this example, the second magnetic resonance imaging reconstruction method may be a PI reconstruction method such as SENSE. According to this example, the excluded steps may comprise a weighting step for application of a sensitivity of the receive coils to the respective subset of k-space data and/or a weighting step for application of a compensation of sampling density variations in k-space to the respective k-space data.

Excluding these two steps may improve the noise characteristics for the denoising for the following reasons. Reconstructed images may exhibit a spatially varying noise level, which primarily depends on the sensitivity of the receive coil elements and on the sampling pattern of the acquisition. They also feature local and global noise correlation, especially if the acquisition is accelerated by subsampling. Both phenomena complicate a denoising, since they either are accurately modeled, in which case the denoising gets tailored to a particular acquisition and loses wider applicability, or they are broadly covered, in which case the denoising suffers from suboptimal performance due to excessive generalization.

According to one example, the excluded steps may comprise: a step of sampling density compensation and a step of correlation weighting. The correlation weighting may be used with a PROPELLER acquisition technique. The correlation weighting may be a down-weighting of data from blades that correlate poorly with a reference blade, as a means to reduce artifacts from through-plane motion. The excluded steps may further comprise a contrast weighting step e.g., preferring data acquired close to the nominal echo time over data acquired much earlier or later, as a means to improve contrast. The excluded steps may further comprise a signal decay correction step e.g., for scaling data to compensate for an expected decay of the signal during the acquisition, as a means to avoid resulting artifacts. This example may be advantageous as it excludes from the first magnetic resonance image reconstruction method a maximum number of processing steps that can render the denoising inefficient.

According to one example, the subsampled k-space data comprises multiple subsets of k-space data that have been acquired in accordance with a PROPELLER acquisition technique using multiple receive coils. Each subset of k-space data represents: one PROPELLER blade, or one PROPELLER blade that has been acquired by a specific receive coil of the receive coils. In this case, the N aliased images comprise one aliased image per subset of k-space data of the subsets of k-space data. The number of subsets of k-space data may be equal to N the number of produced aliased images. The denoised k-space data comprises N subsets of denoised k-space data, one per denoised aliased image. The sampling pattern in each subset of denoised k-space data is the sampling pattern used in the corresponding received noisy subset of k-space data.

The PROPELLER acquisition technique may define the number D of blades, where the number of blades D may be higher than or equal to the number of slices S (e.g., S=D in case one slice is provided per blade), wherein each blade is subsampled in the phase encoding direction by a factor F. The width of the blade becomes (L/F). L is the initial number of lines along the phase direction in the blade that enable a full sampling of k-space of the blade. The field of view of each blade in k-space may be the same. In addition, the sampling pattern in each blade in k-space may be the same. This may enable a uniform subsampling. One or more (R>=1) receive coils may be used to acquire the subsampled k-space data. If each subset of k-space data represents one respective PROPPLER blade, the whole received subsampled k-space data may comprise a number N of subsets of k-space data which is equal to the number of blades, N=D. If the subset of k-space data represents one PROPPLER blade that has been acquired by a specific receive coil of the receive coils, the whole received subsampled k-space data may comprise a number N of subsets of k-space data which is the product of the number of blades and the number of receive coils, N=D×R.

According to one example, the denoising of the aliased images comprises: grouping the aliased images according to the respective blades. Alternatively, the denoising of the aliased images comprises: grouping the aliased images according to the respective receive coils. Alternatively, the denoising of the aliased images comprises: grouping the aliased images according to the respective blades and receive coils. The grouping may result in groups of aliased images. The denoising may be performed jointly for each group of aliased images of the groups of aliased images. This example may enable the joint denoising of aliased images for the SENSE technique or the PROPELLER technique. The joint denoising may, for example, be performed using a technique as described in Jelle Veraart et al., NeuroImage 142 (2016) 394-406.

According to one example, the one or more groups of aliased images comprises:
groups of aliased images representing the PROPELLER blades, respectively, or groups of aliased images whose k-space data have been acquired by the receive coils, respectively, or groups of aliased images representing the PROPELLER blades and receive coils, respectively. This may enable to perform the joint denoising of the aliased images from all blades, from all receive coil elements, or from all blades and all receive coil elements.

According to one example, the subsampled k-space data comprises multiple subsets of k-space data that have been acquired using multiple receive coils, respectively, wherein the at least one aliased image comprises one aliased image per subset of k-space data of the subsets of k-space data, wherein the denoised k-space data comprises one subset of denoised k-space data per denoised aliased image.

According to one example, the denoising of the N aliased images may be a partial denoising. Only a partial denoising of the aliased images may be performed to reduce the risk of eliminating structures.

According to one example, the denoising of the N aliased images may be performed using a trained machine learning model. The machine learning model comprises a convolutional neural network (CNN). Examples of neural networks which may be used for denoising images include: DnCNN, Recurrent CNN, UNet, and Simplified DenseNet. In particular, Mohan et. al. describe a deep convolutional neural network in "Robust and interpretable blind image denoising via bias-free convolutional neural networks" (arXiv: 1906.05478) which may be suitable for implementing the noise filtering module.

According to one example, the first magnetic resonance image reconstruction method may be a Fourier transformation and the second magnetic resonance image reconstruction method may be a combined compressed sensing (CS) and parallel imaging (PI) method. According to this example, the received subsampled k-space data may comprise multiple subsets acquired using the PROPELLER technique, wherein each subset of k-space data represents one PROPELLER blade, or one PROPELLER blade that has been acquired by a specific receive coil of the receive coils.

According to one example, the subsampled k-space data have been acquired to reduce the field of view by a percentage value that is smaller than a defined threshold. For example, the subsampled k-space data may be 1.5-fold subsampled k-space data.

In another aspect the invention relates to a computer program comprising machine executable instructions for execution by a computational system; wherein execution of the machine executable instructions causes the computational system to: receive subsampled k-space data that have been acquired for imaging a subject; reconstruct from the subsampled k-space data at least one aliased image using a first magnetic resonance image reconstruction method; denoise the at least one aliased image; derive from the at least one denoised aliased image k-space data, referred to as denoised k-space data, using a Fourier transformation; reconstructing from the denoised k-space data a magnetic resonance image of the subject using a second magnetic resonance image reconstruction method, the second magnetic resonance image reconstruction method comprising the first magnetic resonance image reconstruction method and additional processing operations.

In another aspect the invention relates to a method for magnetic resonance image reconstruction. The method comprises: receiving subsampled k-space data that have been acquired for imaging a subject; reconstructing from the subsampled k-space data at least one aliased image using a first magnetic resonance image reconstruction method; denoising the at least one aliased image; deriving from the at least one denoised aliased image k-space data, referred to as denoised k-space data, using a Fourier transformation; reconstructing from the denoised k-space data a magnetic resonance image of the subject using a second magnetic resonance image reconstruction method, the second magnetic resonance image reconstruction method comprising the first magnetic resonance image reconstruction method and additional processing operations.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a `circuit,' 'module' or 'system.' Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, television screen, touch screen, tactile electronic display, braille screen, cathode ray tube (CRT), storage tube, bi-stable display, electronic paper, vector display, flat panel display, vacuum fluorescent display (VF), light-emitting diode (LED) display, electroluminescent display (ELD), plasma display panels (PDP), liquid crystal display (LCD), organic light-emitting diode display (OLED), a projector, and head-mounted display.

k-space data is defined herein as being the recorded measurements of radiofrequency signals emitted by atomic spins using the antenna of a magnetic resonance apparatus during a magnetic resonance imaging scan. Magnetic resonance data is an example of tomographic medical image data.

A magnetic resonance image or MR image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flowchart of a method of reconstructing a magnetic resonance image;
Fig. 3 illustrates an example of a medical system;
Fig. 4 shows a flowchart of a method of denoising aliased images;
Fig. 5 shows original aliased blades and denoised aliased blades;
Fig. 6 shows a magnetic resonance image obtained without and with using the present method, respectively;
Fig. 7 shows a magnetic resonance image obtained by denoising an image jointly reconstructed from all aliased blades.

### DETAILED DESCRIPTION OF EMBODIMENTS

Like numbered elements in these figures are either equivalent elements or perform the same function. Elements which have been discussed previously will not necessarily be discussed in later figures if the function is equivalent.

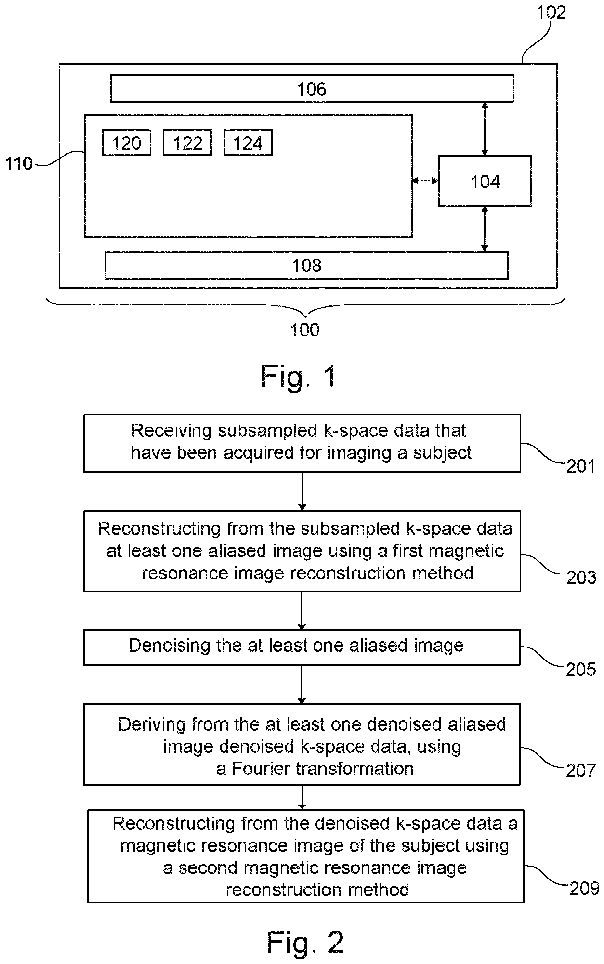

Fig. 1 illustrates an example of a medical system 100. In this example the medical system 100 comprises a computer 102 with a computational system 104. The computer 102 is intended to represent one or more computers or computer systems. The computational system 104 is intended to represent one or more computational systems or computational cores. The computer 102 is further shown as containing an optional hardware interface 106 which is connected to the computational system 104. If other components of the medical system 100 are present or included such as a magnetic resonance imaging system, then the hardware interface 106 could be used to exchange data and commands with these other components. The medical system 100 is further shown as comprising an optional user interface 108 which may provide various means for relaying data and receiving data and commands from an operator.

The medical system 100 is further shown as comprising a memory 110 that is connected to the computational system 104. The memory 110 is intended to represent various types of memory which may be accessible to the computational system 104. The memory 110 is shown as containing machine-executable instructions 120. The machine-executable instructions 120 are instructions which enable the computational system 104 to perform various control, data processing, and image processing tasks. The memory 110 is further shown as containing subsampled k-space data 122 that have been acquired for imaging a volume of a subject. The subsampled k-space data 122 may, for example, be 1.5-fold subsampled k-space data. The subsampled k-space data 122 may, for example, be used to reconstruct a magnetic resonance image 124 of the volume in accordance with the present subject matter.

Fig. 2 is a flowchart of a method for magnetic resonance image reconstruction in accordance with an example of the present subject matter. For the purpose of explanation, the method described in Fig. 2 may be implemented in the system illustrated in Fig. 1, but is not limited to this implementation. The method may, for example, be performed by the medical system 100.

Subsampled k-space data (e.g., 122) that have been acquired for imaging a subject may be received in step 201. At least one aliased image may be reconstructed in step 203 from the subsampled k-space data using a first magnetic resonance image reconstruction method. The at least one aliased image may be denoised in step 205. Denoising may be employed to boost the signal-to-noise ratio. Different methods may be used for denoising. For example, methods relying on convolutional neural networks may be particularly advantageous. They may be applied either on complex or magnitude images.

Denoised k-space data may be derived in step 207 from the at least one denoised aliased image using a Fourier transformation.

A magnetic resonance image of the subject may be reconstructed in step 209 from the denoised k-space data using a second magnetic resonance image reconstruction method. The second magnetic resonance image reconstruction method comprises the first magnetic resonance image reconstruction method and additional processing operations.

The first magnetic resonance image reconstruction method may, for example, be derived from the second magnetic resonance image reconstruction method. The first magnetic resonance image reconstruction method may be the second magnetic resonance image reconstruction method excluding at least part of the additional processing steps. The first magnetic resonance image reconstruction method may be used to reconstruct the aliased image from the subsampled k-space data. The noise level in the produced aliased image may be different from the noise level that would otherwise have been obtained if the aliased image were reconstructed using the second magnetic resonance image reconstruction method. This is because any additional processing step may affect the noise such that the denoising is rendered inefficient. The present subject matter may improve the denoising of magnetic resonance images by using the first magnetic resonance image reconstruction method followed by the second magnetic resonance image reconstruction method.

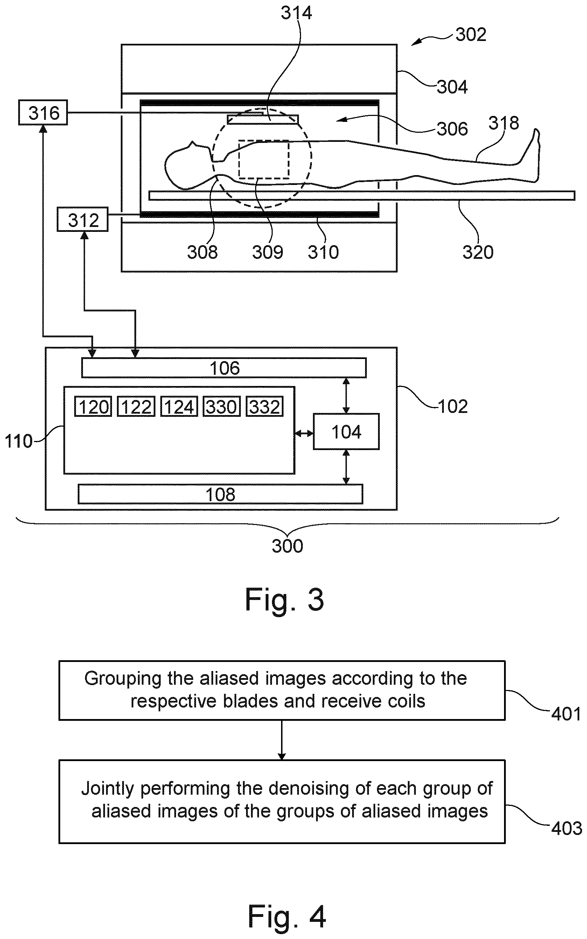

Fig. 3 illustrates a further example of the medical system 300. The medical system in Fig. 3 is similar to that in Fig. 1 except that it additionally comprises a magnetic resonance imaging system 302 that is controlled by the computational system 104.

The magnetic resonance imaging system 302 comprises a magnet 304. The magnet 304 is a superconducting cylindrical type magnet with a bore 306 through it. The use of different types of magnets is also possible; for instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data that is acquired is typically acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radiofrequency coil 314 for manipulating the orientations of magnetic spins within the imaging zone 308 and for receiving radio transmissions from spins also within the imaging zone 308. The radiofrequency antenna may contain multiple coil elements. The radiofrequency antenna may also be referred to as a channel or antenna. The radiofrequency coil 314 is connected to a radiofrequency transceiver 316. The radiofrequency coil 314 and radiofrequency transceiver 316 may be replaced by separate transmit and receive coils and a separate transmitter and receiver. It is understood that the radiofrequency coil 314 and the radiofrequency transceiver 316 are representative. The radiofrequency coil 314 is intended to also represent a dedicated transmit antenna and a dedicated receive antenna. Likewise, the transceiver 316 may also represent a separate transmitter and receivers. The radiofrequency coil 314 may also have multiple receive/transmit elements and the radiofrequency transceiver 316 may have multiple receive/transmit channels.

The transceiver 316 and the gradient controller 312 are shown as being connected to the hardware interface 106 of the computer system 102.

The memory 110 is further shown as containing pulse sequence commands 330. The pulse sequence commands 330 are commands or data which can be converted into commands which enable the computational system 104 to control the magnetic resonance imaging system to acquire subsampled k-space data 332. The memory 110 shows the subsampled k-space data 332 that has been acquired by controlling the magnetic resonance imaging system with the pulse sequence commands 330.

Fig. 4 is a flowchart of a method for denoising aliased images in accordance with an example of the present subject matter. For the purpose of explanation, the method described in Fig. 4 may be implemented in the system illustrated in Fig. 1, but is not limited to this implementation. The method may, for example, be performed by the medical system 100, wherein the subsampled k-space data 122 are acquired using the PROPELLER acquisition technique.

The aliased images may be grouped in step 401 according to the respective blades and receive coils, resulting in groups of aliased images. A joint denoising of each group of aliased images of the groups of aliased images may be performed in step 403.

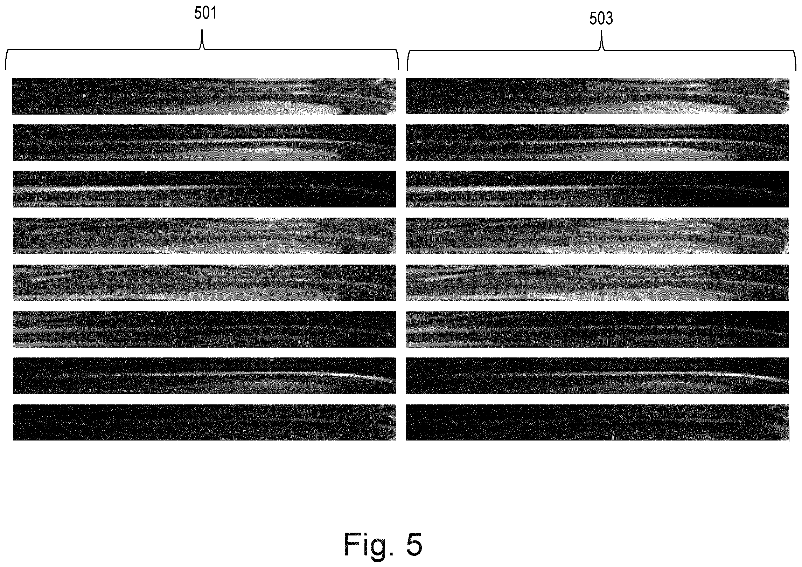

Figs. 5-7 show example results with a PROPELLER acquisition in shoulder imaging, with a number D of blades D=46 and number R of receive coils R=15. Fig. 5 shows original aliased blades 501 and the denoised aliased blades 503. In Fig. 5, aliased images reconstructed with a Fourier transform from 1.5-fold subsampled k-space data from 1 out of 46 blades are shown for 8 out of 15 receive coil elements. They are not weighted by the sensitivity of the receive coil elements, as typically done in a coil combination. Thus, the noise level is still spatially invariant. However, they have been scaled to equalize the noise level across the receive coil elements. The k-space data are not weighted according to the sampling density either, as usually performed in a joint reconstruction of the k-space data from all blades. Therefore, the noise is also still uncorrelated. A denoising with CNNs, trained to remove white noise only, is applied to these aliased images. With an inverse Fourier transform, the aliased images are again turned into 1.5-fold subsampled k-space data from individual blades and receive coils elements. These k-space data are then jointly subjected to an image reconstruction, in this case a combined compressed sensing (CS) and parallel imaging (PI) method.

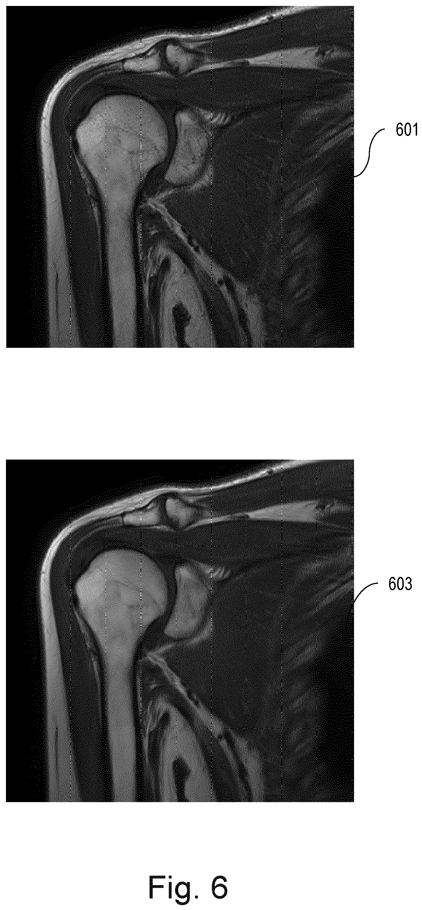

Fig. 6 shows the original image 601 and the processed image 603 obtained by a denoising of the individual aliased blades 501 in image space, as illustrated in Fig. 5.

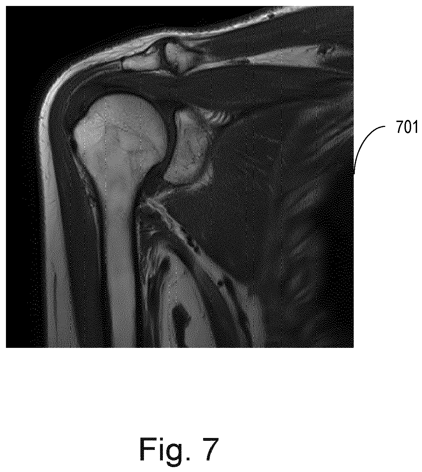

In Fig. 7, the image 701 obtained by directly performing the same denoising trained to remove white noise only on the original image 601 from Fig. 6 is provided. Unlike the processed image 603 in Fig. 6, the noise is suppressed very inhomogeneously and the noise level appears even more nonuniform.

## Claims

1. A medical system for magnetic resonance image reconstruction, the medical system comprising: a memory storing machine executable instructions; and a computational system, wherein execution of the machine executable instructions causes the computational system to:
receive subsampled k-space data that have been acquired for imaging a subject;
reconstructing from the subsampled k-space data at least one aliased image using a first magnetic resonance image reconstruction method;
denoise the at least one aliased image;
derive from the at least one denoised aliased image k-space data, referred to as denoised k-space data, using a Fourier transformation;
reconstruct from the denoised k-space data a magnetic resonance image of the subject using a second magnetic resonance image reconstruction method, the second magnetic resonance image reconstruction method comprising the first magnetic resonance image reconstruction method and additional processing operations.

2. The medical system of claim 1, the first magnetic resonance image reconstruction method consisting of a Fourier transformation operation.

3. The medical system of claim 1, the first magnetic resonance image reconstruction method comprising a Fourier transformation operation and a selected subset of the additional processing operations, wherein the non-selected processing operations are operations which are non-uniformly applied to the subsampled k-space data.

4. The medical system of claim 1 or 3, wherein the subsampled k-space data have been acquired using one receive coil or multiple receive coils, the first magnetic resonance image reconstruction method comprising a Fourier transformation operation and a selected subset of the additional processing operations, wherein the non-selected processing operations comprise at least one of:
a weighting operation for application of a sensitivity of the receive coils to the respective k-space data, and
a weighting operation for application of a compensation for sampling density variations in k-space to the respective k-space data.

5. The medical system of any of the preceding claims, the subsampled k-space data comprising multiple subsets of k-space data that have been acquired using multiple receive coils, respectively; wherein the at least one aliased image comprises one aliased image per subset of k-space data of the subsets of k-space data, wherein the denoised k-space data comprises one subset of denoised k-space data per denoised aliased image.

6. The medical system of any of the preceding claims 1 to 4, the subsampled k-space data comprising multiple subsets of k-space data that have been acquired in accordance with a Periodically Rotated Overlapping Parallel Lines with Enhanced Reconstruction, PROPELLER, acquisition technique; wherein the at least one aliased image comprises one aliased image per subset of k-space data of the subsets of k-space data, wherein the denoised k-space data comprises one subset of denoised k-space data per denoised aliased image, wherein each subset of k-space data represents:
one PROPPLER blade, or
one PROPPLER blade that has been acquired by a specific receive coil.

7. The medical system of claim 5 or 6, wherein each subset of k-space data of the subsets of k-space data is subsampled k-space data, wherein the subsets of k-space data are uniformly subsampled in the phase encoding direction.

8. The medical system of any of the preceding claims 5 to 7, wherein execution of the machine executable instructions causes the computational system to perform the denoising of the aliased images by:
grouping the aliased images according to the respective blades and/or receive coils, resulting in groups of aliased images;
jointly performing the denoising of each group of aliased images of the groups of aliased images.

9. The medical system of claim 8, the one or more groups of aliased images comprising:
groups of aliased images representing the PROPELLER blades, respectively;
groups of aliased images whose k-space data have been acquired by the receive coils, respectively; or
groups of aliased images representing the PROPELLER blades and receive coils, respectively.

10. The medical system of any of the preceding claims, wherein the medical system further comprises a magnetic resonance imaging system, wherein the memory further contains pulse sequence commands configured to control the magnetic resonance imaging system to acquire k-space data according to the magnetic resonance imaging protocol, wherein execution of the machine executable instructions further causes the computational system to: acquire the subsampled k-space data by controlling the magnetic resonance imaging system.

11. The medical system of claim 10, the magnetic resonance imaging system comprising multiple receive coils for receiving the subsampled k-space data.

12. The medical system of any of the preceding claims, wherein execution of the machine executable instructions causes the computational system to perform the denoising of the at least one aliased image partially.

13. The medical system of any of the preceding claims, wherein execution of the machine executable instructions causes the computational system to perform the denoising of the at least one aliased image using a trained machine learning model, the machine learning model comprising a convolutional neural network, CNN.

14. A computer program comprising machine executable instructions, wherein execution of the machine executable instructions causes a computational system to:
receive subsampled k-space data that have been acquired for imaging a subject;
reconstructing from the subsampled k-space data at least one aliased image using a first magnetic resonance image reconstruction method;
denoise the at least one aliased image;
derive from the at least one denoised aliased image k-space data, referred to as denoised k-space data, using a Fourier transformation;
reconstruct from the denoised k-space data a magnetic resonance image of the subject using a second magnetic resonance image reconstruction method, the second magnetic resonance image reconstruction method comprising the first magnetic resonance image reconstruction method and additional processing operations.

15. A method for magnetic resonance image reconstruction, the method comprising:
receiving subsampled k-space data that have been acquired for imaging a subject;
reconstructing from the subsampled k-space data at least one aliased image using a first magnetic resonance image reconstruction method;
denoising the at least one aliased image;
deriving from the at least one denoised aliased image k-space data, referred to as denoised k-space data, using a Fourier transformation;
reconstructing from the denoised k-space data a magnetic resonance image of the subject using a second magnetic resonance image reconstruction method, the second magnetic resonance image reconstruction method comprising the first magnetic resonance image reconstruction method and additional processing operations.
